(19) Europäisches Patentamt
European Patent Office
Office européen des brevets

(11) **EP 0 957 116 B1**

(12) **EUROPEAN PATENT SPECIFICATION**

(45) Date of publication and mention
of the grant of the patent:
**06.06.2007 Bulletin 2007/23**

(51) Int Cl.:
***C08F 246/00*** *(2006.01)*   ***C08F 220/34*** *(2006.01)*
***C09J 4/02*** *(2006.01)*

(21) Application number: **99111804.3**

(22) Date of filing: **15.06.1994**

(54) **Energy-curable ethylenically unsaturated compositions**

Energie härtbare ethylenisch ungesättigte Zusammensetzungen

Compositions à base de insaturation ethylénique durcissables par énergie

(84) Designated Contracting States:
**CH DE ES FR GB IT LI SE**

(30) Priority: **16.06.1993 US 78981**

(43) Date of publication of application:
**17.11.1999 Bulletin 1999/46**

(62) Document number(s) of the earlier application(s) in
accordance with Art. 76 EPC:
**94920217.0 / 0 726 921**

(73) Proprietor: **MINNESOTA MINING AND
MANUFACTURING COMPANY**
**St. Paul,**
**Minnesota 55133-3427 (US)**

(72) Inventors:
• **McCormick, Fred B.**
**Maplewood, MN 55119 (US)**
• **Drath, David**
**Woodbury, MN 55119 (US)**
• **Gorodisher, Ilya,**
**Stillwater, MN 55082, (US)**
• **Palazzotto, Michael C.**
**St.Paul, MN 55116 (US)**
• **Sahyun, Melville R.V.**
**Maplewood, MN 55119, (US)**

(74) Representative: **Vossius & Partner**
**Siebertstrasse 4**
**81675 München (DE)**

(56) References cited:
EP-A- 0 126 712    DE-A- 2 628 417
DE-A- 3 114 250    US-A- 3 833 404

• **PATENT ABSTRACTS OF JAPAN vol. 16, no. 537
(C-1003) [5580], 6 November 1992 (1992-11-06) &
JP 04 202353 A (NIPPON SYNTHETIC CHEM IND
CO LTD)**

EP 0 957 116 B1

**Description**

This invention relates to vibration-damping polymers and methods for making these polymers that comprise a blend of two or more partially polymerized mixtures that are predominately ethylenically unsaturated acrylic monomers.

Industry is constantly searching for lighter, stronger, and more resistant materials to be used in place of the materials used today. Cyanate ester resins are known for their thermal stability, chemical inertness, solvent resistance, and electrical properties. Thus, more and more uses are being found in a variety of fields which demand high performance materials, such as structural composites, printed wiring boards, semiconductor encapsulants, structural adhesives, injection molding and prepregs, and high performance binders. The high performance characteristics of cyanate ester resins are offset by their brittleness. To expand their utility, several strategies have been pursued to toughen these materials.

Several patents have dealt with curable compositions comprising cyanate ester monomers and ethylenically unsaturated monomers. See, for example, U.S. Patent Nos. 4,600,760, 4,116,946, and 4,383,903. Catalysts used for cyanate cure are metal salts, such as zinc octoate, cobalt naphthanate, or certain amines. Use of organometallic catalysts was not taught or suggested. No control over morphology was taught in any of the references.

Cyanate ester resins are formed from polyfunctional cyanate monomers. The use of an organometallic compound as thermal and/or photocatalyst for the cure of a cyanate ester resin has been described in U.S. Patent No. 5,215,860.

Polymerization of ethylenically unsaturated monomers by thermally or photochemically generated free radicals is well known in the art (see J. M. G. Cowie in "Comprehensive Polymer Science", G. Allen and J.C. Bevington, Eds., Pergamon Press, Oxford, 1989, Vol 3, pages 1-15). Typical free radical generators include organic peroxides, onium salts, azo compounds, and carbonyl compounds.

The use of photoreactive organometallic transition metal carbonyl complexes in conjunction with organic compounds, such as organohalo compounds (H.M. Wagner and M.D. Purbrick, *J. Photographic Sci.* **1981,** *29,* 230) and electron accepting olefins (C. H. Bamford and S. U. Mullik, *J. Chem. Soc. Faraday I* **1976**, *72,* 368), in free radical curing is known. For example, benzenechromium tricarbonyl with $CCl_4$, has been used to photopolymerize methyl methacrylate (C. H. Bamford and K. G. Al-Lamee, *J. Chem. Soc. Faraday I* **1984**, 80, 2175) and styrene (C. H. Bamford and K. G. Al-Lamee, *J. Chem. Soc. Faraday I* **1984**, *80,* 2187); in both cases, the active initiating species has been shown to be the $CCl_3$ radical and little or no curing occurs in the absence of $CCl_4$.

Gatechair et al. (U. S. Patent No. 4,707,432) has shown the combination of certain cationic organometallic complexes, such as ferrocenium salts, with a-cleavage photoinitiators, such as acetophenone, to be useful photoinitiator systems for free radical polymerizations. DeVoe and Palazzotto (EPO Publication No. 0 344 911 A2) have further shown that certain cationic organometallic complexes by themselves are useful photoinitiators for acrylic polymerizations.

Cyanate ester resins have been proposed for use in vibration damping. U.S. Patent No. 4,223,073 describes the use of polycyanurates in "high temperature damping" composites. These are single component systems in that cyanate ester groups are the only polymerizable groups present; thus, little control is possible over morphologies of the cured resin. Damping properties are varied by changing the organic backbones of the polycyanurates and the effective dampers are not based on commercially available resins. Further, the "high temperature damping" appears to refer to temperatures of around 100°C. Japanese Patent Applications 4,202,316, 4,202,353 and 4,202,354 all describe vibration damping materials comprising preformed saturated polyesters and cyanate ester monomers.

U.S. Patent No. 3,833,404 discloses a viscoelastic layer for use in a damping means for a vibratory part, the layer being an interpenetrating polymeric network (IPN) which is broadly stated to consist essentially of an elastomer and a plastic. The IPN is prepared sequentially where the first component is cured in the absence of the second component which is then added by swelling or combining the two components as latexes. There is no disclosure to simultaneous or sequential formation of the networks in the presence of both components. The networks are independently crosslinked and continuous.

US Patent No. 3,605,953 discloses the use of a viscoelastic layer in a damping construction for use in a building structure subject to subsonic oscillations such as may be caused, for example, by wind or by earth movements. The viscoelastic material is disclosed to consist of a copolymer of an alkyl acrylate and at least one of acrylic acid, methacrylic acid, acrylonitrile, methacrylonitrile, acrylamide, and methacrylamide. The use of methacrylate polymers as the sole viscoelastic component is disclosed, but only with the addition of plasticizers. The glass transition temperature of the viscoelastic material is described to be between 5 and -50°C. The use of a semi-IPN of acrylates and methacrylates for vibration-damping purposes is not disclosed.

Electronic adhesives based on cyanate ester compositions cured with organometallic catalysts have been described in U.S. Patent Number 5,143,785. Cyanate esters are combined with preformed thermoplastic polymers, conductive particles, catalysts and coupling agents in a solvent such as tetrahydrofuran and preferably coated on a release liner to provide an adhesive film. Only the cyanate ester component is cured by the organometallic catalyst because the other component is prepolymerized.

Briefly, the present invention provides, according to a first aspect, a curable composition comprising at least one ethylenically unsaturated monomer and as initiator a transition metal-containing organometallic compound having the formula

$$[L^1L^2M]$$

wherein

$L^1$ represents 1 ligand contributing pi-electrons that can be the same or different selected from acyclic and cyclic unsaturated compounds and groups and carbocyclic aromatic and heterocyclic aromatic compounds, each capable of contributing 2 to 24 pi-electrons to the valence shell of M;

$L^2$ represents 1 to 6 ligands that can be the same or different contributing an even number of sigma-electrons that can be selected from mono-, di-, and tri-dentate ligands, each donating 2, 4, or 6 sigma-electrons to the valence shell of M;

and M represents metal atom 1 to 4 of the same or different metal atoms selected from the elements of Periodic Groups IVB, VB, VIB, VIIB, and VIII (commonly referred to as transition metals).

According to a second aspect, the present invention refers to a method comprising the steps:

a) providing at least two polymerizable mixtures, each comprising at least one ethylenically unsaturated monomer and a free-radical generating agent,

b) independently partially prepolymerizing each of said ethylenically unsaturated monomers to provide at least two partially prepolymerized syrups, and

c) combining said partially prepolymerized syrups and completing polymerization of said mixture.

According to a third aspect, the present invention provides a polymerizable mixture comprising two or more syrups, wherein each syrup comprises an acrylic polymer and an acrylic monomer, said acrylic polymers differing in either their monomer type or relative amount of each monomer type, said acrylic monomers differing in either their type or relative amount.

According to a fourth aspect, the present invention provides a vibration damping material prepared by the method described above

According to a fifths aspect, the present invention provides a vibration damping device comprising a vibration damping material as described above, optionally said VDM being located and permanently attached between two rigid sheets.

Hence, in the present invention a combination of the independently partially polymerized ethylenically unsaturated monomers may be used without the addition of cyanate ester or its curatives.

The curing agents for both monomers independently may be thermally or photochemically activated.

In another aspect, processing methods for controlling the sequence of cure of the components and thereby controlling the morphology, and thus the properties, of the cured composition are provided. The polymer precursors may be cured by a sequential or simultaneous curing process.

This invention provides a method for preparing coated articles containing the cured composition of the invention comprising the steps of:

(a) providing a substrate,

(b) coating an energy polymerizable mixture as described above onto at least one surface of said substrate by methods known in the art, such as bar, knife, reverse roll, knurled roll, or spin coatings, or by dipping, spraying, brushing, and the like, with or without a coating solvent, and

(c) applying energy (after evaporation of solvent if present) to the article to cause the polymerization of the coating.

This invention also provides shaped articles comprising the polymerizable mixture of the invention. The articles can be provided, for example, by techniques such as molding, injection molding, casting, and extrusion. Applying energy to the mixture causes polymerization and provides the cured shaped article.

In yet another aspect, cured articles comprising the composition of the invention are disclosed.

The compositions are useful, for example, in applications requiring high performance, such as high temperature performance to 350°C or higher; in composites, particularly structural composites; structural adhesives; photodefinable adhesives; vibration damping materials; electronic applications such as printed wiring boards, semiconductor encapsulants and electronic adhesives; injection molding and prepregs; and high performance binders. In addition, the mixed partially polymerized syrup compositions are useful as precursors for making vibration damping materials whose applications include constrained layer and bi-directional damping.

The process requires no means to remove solvents, such as drying ovens, and provides essentially no volatile matter.

In yet another aspect, the invention provides a viscoelastic material used as part of a construction which is useful for damping subsonic oscillations of a building. This is referred to as bi-directional damping. The viscoelastic material is a semi-interpenetrating polymer network (IPN) comprised of the cured product of a combination of independently partially polymerized ethylenically unsaturated monomers. These constructions comprise:

A. at least two rigid members, each having a stiffness exceeding that of a 0.254 cm steel plate, and having at least one broad surface closely spaced from a broad surface of an adjacent of said rigid members, and

B. a layer of viscoelastic material which is a polymeric semi-IPN derived from a combination of independently partially polymerized ethylenically unsaturated monomers, which has a tan delta ($\delta$) greater than or equal to 0.4 in the temperature range of -60°C and 200°C and in the frequency range of 0.1 to 10Hz, as evaluated by a Seiko DMS 200 Rheometer in tension mode or a Seiko DMS 120 Rheometer in shear mode, and

C. a means of attaching said viscoelastic polymer to the rigid substrates, either through its own adhesive nature or by use of a stiff adhesive such as epoxy.

This material is also useful as the viscoelastic material in a constrained layer construction.

As explained above, in one aspect, curable compositions comprise at least one ethylenically unsaturated monomer and as initiator certain organometallic neutral compounds. These compositions are not prior disclosed. They are useful in the graphic arts.

Further, in the present invention, the use of a combination of independently partially polymerized ethylenically unsaturated monomers to form a semi-IPN which is useful in bi-directional and constrained layer damping is taught. There is a clear need based on the art for effective vibration damping materials with broad utility windows.

Advantages of compositions of the present invention include:

solvents are not required, thus 100% solids processing is provided;
morphology of the cured resin can be controllably and reproducibly developed to provide various physical properties from the same combination of monomers by virtue of the processing conditions chosen;
excellent adhesion to polyimide film is attained;
commercially available resins are preferably used;
excellent adhesion to metal, especially steel, as measured by T-peel and overlap shear; and
the blends of the independently partially polymerized ethylenically unsaturated monomers may be cured by a wide variety of combinations of photo and thermal processes.

The invention further teaches the use of a mixture of partially polymerized materials that offer several additional advantages including:

a rapid and simple method for obtaining a semi-IPN made only from ethylenically unsaturated monomers;
uniquely wide temperature and frequency ranges over which effective damping occurs, particularly for seismic damping applications;
and low moisture uptake, and high strain capability (up to 100% shear strain).In this application:

"catalytically-effective amount" means a quantity of catalyst or initiator sufficient to effect polymerization of the curable composition to a polymerized product at least to a degree to cause an increase in the viscosity of the composition;
"cure" and "polymerize" are used interchangeably in this application to indicate a chemical reaction, usually carried out with a catalyst and heat or light, or any combination of the two, in which many relatively simple molecules combine to form a chain-like macromolecule;
"cyanate monomer" or "cyanate ester monomer" are used interchangeably and mean a chemical substance (generally a monomer or oligomer) in which at least one -OCN group is bonded to an organic radical R through the oxygen atom, forming at least one R-OCN bond;
"energy-induced curing" means curing by means of any of electromagnetic radiation (ultraviolet and visible), electron beam, and thermal (infrared and heat) means or any combination thereof such as heat and light simultaneously, or in any sequence, e.g., heat followed by light, light followed by heat followed by light, and the like;

"ethylenically unsaturated" means an organic compound containing at least one carbon-to-carbon multiple bond which, on exposure to free radicals, reacts to form hydrocarbon chains; preferred are vinyl compounds and organic acrylates and methacrylates;

"group" or "compound" or "ligand" or "monomer" or "polymer" means a chemical species that allows for substitution or which may be substituted by conventional substituents which do not interfere with the desired product; e.g., substituents can be alkyl, alkoxy, aryl, phenyl, halo (F, Cl, Br, I), cyano, nitro, etc.;

"organometallic compound" means a chemical substance (ionic salt or neutral compound) in which at least one carbon atom of an organic group is bonded to a transition metal atom ("Basic Inorganic Chemistry", F.A. Cotton, G. Wilkinson, Wiley, New York, 1976, p 497);

"IPN" refers to interpenetrating networks wherein all the components are crosslinked and physically interlocked and to semi-interpenetrating networks wherein only some of the components are crosslinked;

"partially polymerized syrup" and "syrup" mean a composition comprising at least one partially polymerized monomer;

"acrylic monomers" mean ethylenically unsaturated monomers including acrylates, methacrylates, higher alkyl acrylates, acrylamides, methacrylamides, and higher alkyl acrylamides;

"mixed syrup" means a mixture comprising two or more syrups. These mixed syrups are made up of compatible mixtures of monomers and polymers, where compatible means that no gross phase separation occurs before the mixture is polymerized to its final state;

"Polymer A" means the polymeric component of syrup A. Polymer A may be a copolymer;

"Monomer A" means the monomeric component of syrup A. Monomer A may comprises more than one type of monomer. Any of the monomers comprising Monomer A may be a precursor Polymer A. Monomer A may also contain a multifunctional monomer in order to promote the formation of a crosslinked network in the polymerization product of the mixed syrups, helping form a semi-IPN;

"vibration-damping material" (VDM) means a material that absorbs oscillatory energy and is characterized by having a large tan delta ($\delta$) value as measured by dynamic mechanical testing over a desired temperature range and over a desired frequency range.

"utility window" means the difference between the highest temperature and the lowest temperature at which the tan delta value for a particular VDM exceeds a threshold value, typically 0.6, at a particular frequency. The utility window is strongly related to the useful temperature range of the damping material. For some applications, the utility window will be further constrained by the storage modulus (G' or E') falling within a specified range. For example, for bi-directional damping, G' should be between $3.45 \times 10^5$ and $6.9 \times 10^6$ Pa;

"storage modulus" refers to the storage modulus (G' or E') of a material at a particular frequency and temperature. It is measured using dynamic mechanical testing by means well known in the polymer art. See for example "Physical Methods of Chemistry: Vol. VII, Determination of Elastic and Mechanical Properties", R.W. Rossiter and R.G. Baetzold, eds., John Wiley&Sons, New York (1991) p.11;

"bi-directional damping" is defined, as in US Patent 3,605,953 as pertaining to the therein described bi-directional damping unit or to other configurations which could be reasonably construed to perform the same function of transferring subsonic oscillations of a structure, such as a building, into shear deformation of a viscoelastic material for the purpose of damping the oscillations of the structure; and

"radiation sensitive" means may be polymerized or crosslinked by actinic radiation (UV and visible) or electron beam.

Some polymeric compositions will form a semi-interpenetrating polymer network (semi-IPN); some systems a true IPN. Other polymeric compositions will form phase separated morphologies of various domain sizes. Existence of the multiphase structure provides improved toughness and may provide increased strength. Selection of monomers, curing agents, and processing conditions provides means of controlling morphologies of the cured compositions of the invention.

Ethylenically unsaturated monomers useful in the present invention preferably can be selected from acrylate, methacrylate, and vinyl ester functionalized materials and are capable of undergoing free radical polymerization. Of particular use are acrylate and methacrylate materials. They can be monomers and/or oligomers such as (meth)acrylates, (meth)acrylamides, N-vinylpyrrolidone and vinylazlactones as disclosed in U.S. Patent No. 4,304,705, col. 13, lines 34-68, which is incorporated herein by reference. Such monomers include mono-, di-, or polyacrylates and methacrylates such as methyl acrylate, methyl methacrylate, ethyl acrylate, ethyl methacrylate, isopropyl methacrylate, butyl methacrylate, isooctyl acrylate, isobornyl acrylate, isobornyl methacrylate, acrylic acid, n-hexyl acrylate, tetrahydrofurfuryl acrylate, N-vinylcaprolactam, N-vinylpyrrolidone, acrylonitrile, stearyl acrylate, allyl acrylate, glycerol diacrylate, glycerol triacrylate, ethylene glycol diacrylate, diethylene glycol diacrylate, triethylene glycol dimethacrylate, 1,6-hexanediol diacrylate, 1,3-propanediol diacrylate, 1,3-propanediol dimethacrylate, hexane diol dimethacrylate trimethylolpropane triacrylate, 1,2,4-butanetriol trimethacrylate, 2-phenoxyethyl acrylate, 1,4-cyclohexanediol diacrylate, pentaerythritol triacrylate, pentaerythritol tetraacrylate, pentaerythritol tetramethacrylate, sorbitol hexaacrylate, bis[1-(2-acryloxy)]-p-ethoxyphenyldimethylmethane, 2,2-bis[1-(3-acryloxy-2-hydroxy)]propoxyphenylpropane, tris(hydroxyethyl)isocyanurate trimethacrylate; the bis-acrylates and bis-methacrylates of polyethylene glycols of molecular weight average 200-500, copolymerizable mixtures of acrylated monomers such as those disclosed in U.S. Patent No. 4,652,27.4, col. 2, line 55 to col. 4, line 68, and acrylated oligomers such as those disclosed in U.S. Patent No. 4,642,126, col. 4, lines 31-50, which patents are incorporated herein by reference for the portions indicated.

It may be desirable to crosslink the ethylenically unsaturated components of the polymerizable compositions of the invention. Particularly useful as crosslinker compounds are acrylates such as allyl acrylate, glycerol diacrylate, glycerol triacrylate, ethylene glycol diacrylate, diethylene glycol diacrylate, triethylene glycol dimethacrylate, 1,6-hexanediol diacrylate, 1,3-propanediol diacrylate, 1,3-propanediol dimethacrylate, trimethylolpropane triacrylate, 1,2,4-butanetriol trimethacrylate, 1,4-cyclohexanediol diacrylate, pentaerythritol triacrylate, pentaerythritol tetraacrylate, pentaerythritol tetramethacrylate, sorbitol hexaacrylate, bis[1-(2-acryloxyl)]-p-ethoxyphenyldimethylmethane, 2,2-bis[1-(3-acryloxy-2-hydroxy)]propoxyphenylpropane, tris(hydroxyethyl)isocyanurate trimethacrylate; and the bis-acrylates and bis-methacrylates of polyethylene glycols of average molecular weight 200-500.

Organometallic compounds of the formula $[L^1L^2M]$ surprisingly are photocatalysts for the cure of the ethylenically unsaturated monomers of the invention. Illustrative examples include $MeCpMn(CO)_3$, $(C_6H_6)Cr(CO)_3$, $(MeC_6H_5)Cr(CO)_3$, $(MeOC_6H_5)Cr(CO)_3$, $(C_6H_6)W(CO)_3$, $CpMn(CO)_3$, and $-Cp^*Mn(CO)_3$, wherein Me, Cp, MeCp, and $Cp^*$ are as previously defined.

Other free radical curatives useful for the polymerization of the ethylenically unsaturated monomers include organic peroxides such as benzoyl peroxide and di-t-butylperoxide, azo compounds such as azobisisobutylnitrile (AIBN), benzoin ethers such as benzoin-iso-propyl ether and benzoin-n-butyl ether, acetophenones such as 2,2-diethoxyacetophenone and 2,2-dimethoxy-2-phenylacetophenone, onium salts such as diphenyliodbnium and triphenyl sulfonium salts, ketals such as benzildimethyl ketal, benzophenone, isopropylthioxantone, ethyl-4-(dimethylamino)benzoate, and other free radical curatives known to those skilled in the art. The free radical curatives may be photochemically or thermally activated. Preferred thermally activated free radical curatives include azo-t-butane, 2,2'-azobis(2,4,4trimethylpentane) and di-t-butyl peroxide 1,1-di-(t-butylperoxy)-3,3,5-trimethylcyclohexane. Photochemically activated free radical curatives are preferred and of these benzildimethyl ketal (Esacure™ KB 1 from Sartomer Company) is most preferred.

According to the following method, two or more syrups may be prepared independently, and then combined for use without the addition of any cyanate esters or cyanate ester curatives.

The first step in this method is to mix the ethylenically unsaturated monomers with a catalytically effective amount of a free radical initiator. Preferably, this free radical initiator is not a crosslinking agent and generally is present in amounts in the range of 0.001 to 5.0% by weight of the free radically polymerizable components, and preferably in the range of 0.004 to 1.0% by weight.

The second step is to apply energy to the polymerizable composition and allow it to polymerize such that the Brookfield viscosity is increased to within a range of 300 to 20,000 centipoise at ambient temperature. Preferably, the viscosity after this step is in the range of 500 to 4000 centipoise. The increased viscosity provides a syrup that is more suitable as a coating composition for production of articles of this invention. In addition, the conversion of monomer to polymer is necessary to obtain the desired phase separation and final properties of the cured composition. Processing to provide high performance compositions is assisted when in the range of 1 to 50 weight percent (or that weight percent present up to the gel point of the composition) of monomers are prepolymerized into a syrup. Preferably, 1 to 50 weight percent, and most preferably 5 to 35 weight percent of monomers are prepolymerized.

The ethylenically unsaturated monomers can be polymerized by any well-known thermal polymerization techniques and quenched with air to attain the desired viscosity syrup. It is preferable to use a photoinitiator as the free radical initiator in this process, such that the partial polymerization may be stopped at any point by eliminating the irradiation source and then quenching polymerization with oxygen. It is preferable to use a low intensity irradiation source in this photochemical process, and the mixture may be cooled during irradiation. Low intensity irradiation and cooling minimize gel formation during the syrup making process. By "cooling" is meant to keep the composition at or below room temperature.

Photoinitiators which are useful for partially polymerizing alkyl acrylate monomers without crosslinking, to prepare a partially polymerized syrup, include compounds such as the benzoin ethers (such as benzoin methyl ether or benzoin isopropyl ether), substituted benzoin ethers (such as anisoin methyl ether), substituted acetophenones (such as 2,2-diethoxyacetophenone and 2,2-dimethoxy-2-phenylacetophenone), substituted alpha-ketols (such as 2-methyl-2-hydroxypropiophenone), aromatic sulfonyl chlorides (such as 2-naphthalenesulfonyl chloride) and photoactive oximes

After quenching the polymerization reaction in each syrup, and combining two or more syrups, optional bireactive monomers, ethylenical ly unsaturated crosslinkers, adjuvants and additional free radical initiators may be added. The curing agents can be present in the range of 0.005 to 20, preferably 0.1 to 5 weight percent of the total composition.

The composition is then thoroughly mixed to evenly distribute the components.

The curable compositions are degassed under vacuum to remove bubbles and dissolved air (oxygen). Although it is preferable to do this step just prior to coating, degassing can be carried out at any time from a few hours to several weeks prior to coating. To insure stability of the degassed curable compositions, it is preferable to keep the curable composition from unwanted exposure to light.

In the current state of the art, free radical polymerization preferably is carried out in an inert atmosphere. Any inert atmosphere such as nitrogen, carbon dioxide, helium or argon is suitable. A sufficiently inert atmosphere can be achieved by covering a layer of the polymerizable mixture with a plastic film; for photoactive compositions this should be transparent to ultraviolet radiation to allow irradiating through that film in air. The composition should be kept in low light, or preferably total darkness, in air, vacuum, or inert gaseous atmosphere until ready for polymerization.

It may be desirable to add solvent to solubilize components and aid in processing. Solvent, preferably organic solvent, in an amount up to 99 weight percent, but preferably in the range of 0 to 90 weight percent, most preferably in the range of 0 to 75 weight percent, of the polymerizable composition can be used. Most preferably, the polymerizable composition is solvent-free.

For those compositions of the invention which are radiation-sensitive, any source of radiation including electron beam radiation and radiation sources emitting active radiation in the ultraviolet and visible region of the spectrum (e.g., about 200 to 800 nm) can be used. Suitable sources of radiation include mercury vapor discharge lamps, carbon arcs, tungsten lamps, xenon lamps, lasers, sunlight, etc. The required amount of exposure to effect polymerization is dependent upon such factors as the identity and concentration of catalysts, the particular cyanate ester and ethylenically unsaturated monomers, the thickness of the exposed material, type of substrate, intensity of the radiation source and amount of heat associated with the radiation.

Thermal polymerization using direct heating or infrared electromagnetic radiation, as is known in the art, can be used to cure polymerizable compositions according to the teachings of this invention.

It is within the scope of this invention to use multiple wavelengths of actinic radiation by irradiating the photopolymerizable compositions sequentially. In the preferred method, photopolymerization is effected by sequential exposure to a radiation source emitting active radiation in the visible region of the spectrum, followed by exposure to a radiation source in the ultraviolet region of the spectrum. It is also preferred to heat either during or after irradiation in the visible region. In addition, it may be desirable to subsequently thermally polymerize the activated precursor so obtained, the irradiation temperatures being below the temperature employed for subsequent heat postcuring. These activated precursors may normally be polymerized at temperatures which are substantially lower than those required for direct thermal polymerization, with an advantage in the range from 50 to 110°C. This process also makes it possible to control polymerization in a particularly simple and advantageous manner.

It is within the scope of this invention to include two-stage polymerization (curing), by first activating curing agent by irradiating the curable compositions and subsequently thermally curing the activated precursors so obtained, the irradiation temperature being below the temperature employed for the subsequent heat-curing. These activated precursors may normally be cured at temperatures which are substantially lower than those required for the direct thermal curing, with an advantage in the range from 50 to 150°C. This two-stage curing also makes it possible to control the polymerization in a particularly simple and advantageous manner.

Adjuvants such as solvents, pigments, abrasive granules, stabilizers, light stabilizers, thermoplastics, antioxidants, flow agents, bodying agents, flatting agents, colorants, inert fillers, binders, blowing agents, fungicides, bactericides, surfactants, plasticizers, conductive particles, and other additives as known to those skilled in the art can be added to the compositions of this invention. These can be added in an amount effective for their intended purpose.

Compositions of this invention may be applied, preferably as a liquid, to coat a variety of substrates including metal such as steel, aluminum, copper, cadmium, and zinc; glass, paper, wood, or various plastic films such as polyimide, poly(ethylene terephthalate), plasticized poly(vinylchloride), poly(propylene), poly(ethylene), and the like, and irradiated. By polymerizing part of the coating, as by irradiation through a mask, those sections which have not been exposed to radiation may be washed with a solvent to remove the unpolymerized portions of the compositions while leaving the photopolymerized, insoluble portions in place. Thus, compositions of this invention may be used in the production of articles useful in the graphic arts such as printing plates and printed circuits. Methods of producing printing plates and printed circuits from photopolymerizing compositions are well known in the art (see for example British Patent Specification No. 1,495,746).

The present invention composition can have utility as a vibration damping material. Properties of vibration-damping material are described in the literature. Nielsen, L.E., Mechanical Properties of Polymers, Van Nostrand Reinhold: New York, 1965; pp 162-165, discloses that materials possessing the maximum vibration-damping capability have shear storage moduli, G', greater than $10^7$ dynes/cm$^2$ but less than $10^{10}$ dynes/cm$^2$ at the use temperature. Furthermore, Rosen, S.L., Functional Principles of Polymeric Materials for Practicing Engineers; Barnes and Noble: New York, 1971; pp 222-227, shows that it is desirable for a vibration-damping material to have both a storage modulus and a loss tangent with values as high as possible.

Yerges, L.F., <u>Sound. Noise, and Vibration Control</u>; Van Nostrand Reinhold: New York, 1965; pp 68-69, notes that useful damping materials exhibit decay rates from as low as 5 to 80 dB/sec (decibels/second), and from 1/2 to 20 percent of critical damping. ("Critical" damping is the damping necessary to just prevent oscillation).

An alternate application of vibration damping materials is in a bi-directional damping unit such as is described in US Patent No 3,605,953 which is incorporated here by reference. In this application, materials which have maximum vibration damping capability have shear storage moduli (G') between $3.45 \times 10^5$ Pa and $6.9 \times 10^6$ Pascals at the use temperature, and have a tan delta ($\delta$) as high as possible over some desirable temperature and frequency range. The materials should also have an elongation in tension of at least 100% or a shear strain capability of at least 100% within their use range of temperature and frequency.

Damping materials are applied to structures and component parts in devices to attenuate resonant vibrations and thereby reduce noise and vibrational fatigue. This is often accomplished by attaching a viscoelastic material of appropriate damping characteristics to the vibrating structure. The vibrational forces cause the viscoelastic material to undergo deformation where some of its inelastic deformation energy is converted to heat and then dissipated (mechanical hysteresis). Under cyclic loading, the heat generated results in a temperature rise until the heat generated per cycle is equal to the heat dissipated through conduction, convection and radiation. Thus, the ability of a material to damp is measured by its ability to convert vibrational energy to heat energy.

In viscoelastic materials, the maximum amount of energy is dissipated as heat at the glass-rubber transition temperature. The effectiveness of a viscoelastic material in energy dissipation can be evaluated by measuring its viscoelastic response to a periodic stress or strain. When a polymeric material is subjected to a periodic stress, the degree of polymer viscoelasticity will be reflected in the amount of the viscous lag between the imposed stress wave and the induced strain wave. The Young's Modulus, $E^*$, of a material is a complex number, given by the sum of the storage and dissipation (or loss) terms: $E^* = E' + iE''$. The dissipation term, $E''$, is a measure of how much energy a material can damp or dissipate. The shear modulus, $G^*$, is similarly defined as $G^* = G' + iG''$. The lag, known as d, is the measure in degrees of how much out of phase the stress and strain are. The tangent of d, frequently referred to as the dissipation (or loss) factor, is defined by the ratio of the loss modulus to the storage modulus: tan d = $E''/E'$ or tan d = $G''/G'$. Polymers in their glassy state or in their rubbery plateau have a negligible lag, while viscoelastic materials in the glass transition regime could have a large energy dissipation contribution to the modulus, and thus have a large tan d. Results of dynamic mechanical analysis (DMA) tests are generally given in terms of the storage modulus, E' or G', the loss modulus, E'' or G'', and tan d. Tan d is a damping term and is a measure of the ratio of energy dissipated as heat to the maximum energy stored in the material during one cycle of oscillation. The morphologies of cured resin compositions of the invention are reflected by the shape of the tan d, E', E'', G', or G'' curves obtained by DMA; a single phase system gives a single tan d peak while a multiphase system will give multiple tan d peaks.

The glass transition range of a two (or more) component (meth)acrylate blend can be broadened by causing phase separation between the components before final polymerization. This can be done by making oligomeric solutions (syrups) of each component, to a certain degree of polymerization, then by mixing of the solutions some immiscibility will occur causing the desired phase separation. Immiscibility will occur due to thermodynamic considerations discussed below.

IPNs and semi-IPNs are attractive classes of materials because they have a potential of offering toughened high performance materials with superior adhesive (up to at least 800 g/mm$^2$ shear value) properties from the common and inexpensive polymers and monomers. IPNs have the ability to provide materials with vastly different properties and performance using the same starting components via the variation of the ultimate IPN morphology. Morphology describes the micro and macro molecular architecture, i.e., how intimately the components are mixed on a continuum of size scales. The ability to control this IPN morphology provides for high performance polymers at low cost.

The degree of mixing of polymers in an IPN, or the degree and scale of their phase separation may define the properties of that IPN. Typically, high polymers are highly immiscible due to the entropic considerations; simple blends of preformed polymers usually results in highly phase separated morphologies. The present invention provides the means for simultaneous or sequential formation of IPNs by in situ polymerization of mixtures of monomers; thermodynamically incompatible polymers can in this way be compatibilized by the kinetic routes of the invention described below.

The degree of phase separation (relates to number and size of different phase compositions) in the thermodynamically incompatible IPNs of the invention can be controlled by two key rates; 1) the rate of polymerization or crossliriking of each component and 2) the rate of diffusion of each polymer. Thermodynamics is driving the system to phase separate at the diffusion rate, while kinetics inhibits phase separation by physically interlocking the forming polymer networks through the polymerization and crosslinking reactions. Assuming that the monomeric mixture is a true solution, the degree of incompatibility of the two polymers forming the IPN progressively grows with the increasing molecular weight due to thermodynamic considerations. But at the same time, the increasing molecular weight translates into an increasingly interlocked and intertwined networks of the component polymers. These mechanical interlocks hinder the extensive phase separation of the incompatible networks.

Thus, in a two component system where the polymerized components are incompatible, if the polymerization rate is much faster than the diffusion rate, then the growing polymers will not have time to phase separate and will end up "trapped together" at the gel point. Such IPNs will favor the fully miscible morphology of an idealized IPN. The tan d curve from DMA of such a material will tend to show a single, fairly narrow peak at a temperature which is between the glass transition temperatures of the two component homopolymers and may be calculated by the Fox equation (see L. H. Sperling, "Introduction to Physical Polymer Science", John Wiley & Sons, Inc., New York, 1992, pp 357-360).

In the opposite case where the polymerization is much slower than the diffusion rate, the growing polymers have enough time to phase separate and end up forming a phase separated IPN structure. The tan d curve from DMA of such a material will tend to show two fairly narrow peaks, one each at a temperature near to the glass transition temperatures of the two component homopolymers.

In the case where the polymerization rate is similar to the diffusion rate, the growing polymers will undergo some phase separation and some phase mixing to give a semi-phase separated or microheterogeneously phase separated IPN structure which is intermediate between the first two cases. The semi-phase separated or microheterogeneously phase separated IPNs are defined as those which incorporate a multitude of phase compositions ranging from pure low Tg component to pure high Tg component and their various mixtures. The tan d curve from DMA of such a material will tend to show one very broad peak roughly spanning the temperature range between the glass transition temperatures of the two component homopolymers.

While not wanting to be bound by theory, the semi-phase separated or microheterogeneously phase separated IPNs are the ideal morphology choice for vibration dampers with broad operating temperature ranges. Wide temperature damping in semi-phase separated IPNs is a result of an aggregate molecular architecture consisting of a continual spectrum of compositions, ranging from pure low Tg component to the pure high Tg component.

The morphology comprised of a continuum of phase compositions is characteristic of an IPN formed under mixed kinetic control conditions. A system that either started out under the polymer growth control and later crossed over to the diffusion control, or visa versa, would encounter a regime of mixed controls in between. The degree of the allowed phase separation continually changes in the IPN formation during the change of the controls. Variable amounts of each component are allowed to diffuse in and out of the domains that are in the process of becoming discrete microheterogeneous phases. It is during this time that the phases with a wide range of variable compositions are formed. The desired semi-phase separated morphology may also be defined as a cured or partially cured composition in which tan d, as measured by DMA in the constrained layer mode, is at least 0.03 over 20% or more of the temperature range between the Tg of the pure high Tg component and the Tg of the pure low Tg component.

The control over the morphology of an IPN is a result of the ability to control the rates of diffusion and polymerization. Partial prepolymerization of components, individually or together, provides additional control of these rates. The control is multi-fold: the rates can be varied by the choice of materials, processing and catalytic systems. The materials choice can vary the viscosity or the rigidity of the polymerizing composition via the degree of cross-linking and the Tgs of the selected individual components. Compositions of different viscosities provide differing barriers to both diffusion and propagation.

Processing can greatly vary the rates by simply changing the order in which the IPN components are polymerized. The energy used to cure the components can be adjusted to affect the rates. Thermal cure can be substituted for the photoactivated polymerization to change the pace of the polymerization. Processing can be used to adjust the amount of time which passes between the initiation of each cure, thus allowing greater degree of diffusion and therefore, phase separation.

Choice of catalysts or initiators and amount used can have a profound effect on the polymerization and its speed. Additives can be used to delay or speed up cure of the polymer.

As is known in the art, the most efficient use of a damping material occurs if the material is sandwiched between the panel to be damped and a relatively stiff layer, such as a thin metal sheet. This forces the damping material into shear as the panel vibrates, dissipating substantially more energy than when the material acts simply in extension and compression.

An alternate use of a damping material is in a damping unit for use in a building structure subject to subsonic oscillations such as the wind or earth movements may induce in a tall building. The vibration damping material is sandwiched between at least two rigid members, each having a stiffness exceeding that of 0.254 cm steel plate, said rigid members have attaching means for securing one of said rigid members to one point and for securing another of said rigid members to another point of the building or structure, such points experience relative motion as a result of the oscillations such that the oscillations tend to be damped by shearing forces within the viscoelastic layer.

Solid articles comprising viscoelastic polymeric mixtures of the invention are prepared by either of two processes. In a first process, a layer of the polymerizable mixture is coated onto or between a release liner, the mixture is polymerized, and the layer of resulting polymeric mixtures transferred to a substrate and adhered thereto, thereby providing a constrained-layer construction. In the second process, a layer of the polymerizable mixture is coated directly onto a substrate and the mixture polymerized *in situ* thereby also providing a constrained-layer construction or alternatively a bi-directional damping construction. The constrained-layer construction or bi-directional damping construction is then mechanically (e.g., as by bolting) or adhesively affixed to a solid article that requires vibration damping. Alternatively, the vibration damping layer may be an integral part of the article requiring damping, such as an automotive body panel or a disc brake pad assembly. When the solid article subsequently vibrates under the influence of an internal or external applied force, vibration in the solid article is damped.

Since the viscoelastic polymer often has adhesive properties, the polymer can usually be adhered to a stiff layer or substrate without the use of an adhesive. It is sometimes desirable, however, to use a thin layer (e.g., 20-50 mm) of high-modulus adhesive, such as an acrylic adhesive or an epoxy adhesive, to bond the polymer to a solid article which can be, for example, an oil pan, a valve cover, or a transmission housing.

As mentioned above, a stiff layer or substrate is an essential part of the constrained-layer vibration-damping constructions of the present invention. A suitable material for a substrate has a stiffness of at least 0.40 (relative to stainless steel) as defined in Handbook of Tables for Applied Engineering Science, Bolz, R.E. et al., eds., CRC Press: Cleveland, Ohio, 1974, p 130. The desired stiffness of the substrate is varied by adjusting the thickness of the layer, for example from about 25 micrometers to 5 centimeters, depending on the modulus of the substrate. Examples of suitable materials include metals such as iron, steel, nickel, aluminum, chromium, cobalt and copper, and alloys thereof and stiff polymeric materials such as polystyrene, polyvinylchloride, polyurethane, polycarbonate, and polyepoxide, glass fiber-reinforced plastics such as glass fiber, ceramic fiber, and metal fiber-reinforced polyester, glasses, and ceramics. The process for polymerization of the composition may be completed in one step, or may be divided into several steps separated by an interval of time, where such is preferable.

Vibration damping materials of this invention are particularly useful in high temperature applications and in applications requiring damping over very broad temperature ranges. Damping from less than 0°C to over 300°C are possible with single compositions of this invention.

Materials of this invention, particularly those that are the product of the polymerization of a mixed syrup of two different ethylenically unsaturated monomers, are also particularly useful in damping of subsonic vibrations, and thus lead to devices for damping of seismic vibrations in buildings.

The combining of two or more syrups provides a rapid and simple method of preparing a curable composition which can be processed to form a semi-IPN. The cured mixed syrup compositions of this invention exhibit an improved damping utility window. The temperature and frequency position of this Utility window can be easily adjusted by changing the composition and conversion of the independently partially polymerized ethylenically unsaturated monomers (syrups) as well as the ratio of the individual syrups. The cured composition has a low moisture uptake, a low effect of absorbed moisture on dynamic mechanical properties, and high strain capability.

The damping ability of some compositions improved upon repeated thermal cycling to 300°C. The effective damping range of the compositions of this invention are easily adjusted changing the morphology of the cured compositions; this is controlled by choice of monomers, catalysts, and processing conditions. For example, by varying the relative amounts of the low Tg acrylate in the composition, the Tg range of the ultimate IPN can be shifted.

The wide temperature damping range and excellent thermal stability of the compositions of this invention make these materials useful as sound dampers for automotive brake shoes. Such applications typically require damping from ambient temperatures to about 150°C combined with the ability to withstand 260°C for two hours. The action of the brake piston during the braking requires the polymeric damper constrained between metal plates to withstand over 350 g/mm$^2$ (500 Ib/in$^2$) in shear. Mass production of such constrained layer geometries further requires solution coating or tape laminating of the damping materials onto a metallic sheet that is wound into a coil. The constrained layer damping construction desirably has a T-peel adhesion exceeding 90 g/mm (5 Ib/in) in order to resist degradation during these winding processes. The fine degree of control over intermediate and final morphologies allows a room temperature viscoelastic material to have semi-structural overlap shear, excellent thermal stability, and good T-peel adhesion. For a brake shoe damper, the best morphology is obtained by a three step process; a short thermal cure, followed by a photocure, with a final thermal cure at a higher temperature than the initial thermal cure.

For most applications, the layer of viscoelastic polymer is a coating having a thickness of at least 0.01 mm up to about 100 mm, preferably 0.025 to 100 mm, and most preferably 0.05 to 100 mm. The coating can be applied by any of the techniques known in the art such as by spray, dip, knife, or curtain coating.

The polymerizable (curable) mixtures of the invention can be used to provide a pressure sensitive adhesive, which when coated onto a flexible backing provides a tape, or when the flexible backing has release properties there is provided a transfer tape.

For seismic damping applications, the preferred composition is a polymerizable composition comprising a mixed syrup of poly(isooctyl acrylate-co-isobornyl acrylate) with poly(ethyl methacrylate), with the preferred seismic damping material being the polymerization product of this mixed syrup. The preferred curative is benzildimethyl ketal (KB-1).

Objects and advantages of this invention are further illustrated by the following examples, but the particular materials and amounts thereof recited in these examples, as well as other conditions and details, should not be construed to unduly limit this invention.

In the examples Me = methyl, Ph = phenyl, Cp = cyclopentadienyl, Mes = mesitylene.

All syrups unless otherwise stated were made by adding 0.05% KB-1 by wt. to the monomer and exposed to 350 nm UV light. Partially polymerized syrups can be made as described in U.S. Patent No. 4,330,590, col. 6, lines 32-38, which is incorporated herein by reference for these procedures. The syrup making device allows for constant stirring and rotation along with a $N_2$ purge bubbling through the mixture. The UV light is placed 20.3 cm (8 inches) from the center axis of the jar. Tests have shown that the amount of energy from the lights at this distance is 67 mj/cm$^2$min. The syrups had Brookfield viscosities from 1000 to 3000 cps. Syrups can be partially characterized by the weight percent conversion of monomer to polymer as determined by gravimetric analysis.

The present invention comprises the embodiments of the following items:

1. A curable composition comprising at least one ethylenically unsaturated monomer and as initiator a transition metal-containing organometallic compound having the formula

$$[L^1L^2M]$$

wherein

$L^1$ represents 1 ligand contributing pi-electrons that can be the same or different selected from acyclic and cyclic unsaturated compounds and groups and carbocyclic aromatic and heterocyclic aromatic compounds, each capable of contributing 2 to 24 pi-eledrons to the valence shell of M;

$L^2$ represents 1 to 6 ligands that can be the same or different contributing an even number of sigma-electrons that can be selected from mono-, di-, and tri-dentate ligands, each donating 2, 4, or 6 sigma-electrons to the valence shell of M;

and M represents metal atom 1 to 4 of the same or different metal atoms selected from the elements of Periodic Groups IVB, VB, VIB, VIIB, and VIII (commonly referred to as transition metals).

2. The curable composition according to item 1 wherein said ethylenically unsaturated monomer is an acrylate or methacrylate.

3. A method comprising the steps:

a) providing at least two polymerizable mixtures, each comprising at least one ethylenically unsaturated monomer and a free-radical generating agent,
b) independently partially prepolymerizing each of said ethylenically unsaturated monomers to provide at least two partially prepolymerized syrups, and
c) combining said partially prepolymerized syrups and completing polymerization of said mixture.

4. A polymerizable mixture comprising two or more syrups, wherein each syrup comprises an acrylic polymer and an acrylic monomer, said acrylic polymers differing in either their monomer type or relative amount of each monomer type, said acrylic monomers differing in either their type or relative amount.

5. A polymerizable mixture as in item 4 wherein either Monomer A or Monomer B comprises at least one multifunctional monomer.

6. A polymerizable mixture as in item 5 wherein at least one of the monomers that comprise Monomer A is one of the monomers that comprise Polymer A.

7. A polymerizable mixture as in item 6, wherein at least one of the monomers that comprise Monomer B is one of the monomers that comprise Polymer B.

8. A polymerizable mixture as in item 7 wherein Polymer A comprises at least two different monomers.

9. A polymerizable mixture as in item 8 wherein Polymer B comprises at least two different monomers.

10. A polymerizable mixture as in item 8 wherein Monomer A comprises at least two different monomers.

11. A polymerizable mixture as in item 9 wherein Monomer B comprises at least two different monomers.

12. A polymerizable mixture as in item 5 wherein Polymer A is selected from the group of polyacrylates and polyacrylamides and Polymer B is selected from the group of polymethacrylates, poly alkyl acrylates, polymethacrylamides, and poly alkylacrylamides.

13. A polymerizable mixture as in item 7 wherein Polymer A is selected from the group of polyacrylates and polyacrylamides and Polymer B is selected from the group of polymethacrylates, poly alkyl acrylates, polymethacrylamides and poly alkylacrylamides.

14. A polymerizable mixture as in item 7, wherein Polymer B comprises at least two different monomers and wherein Polymer A is selected from the group of polyacrylates and polyacrylamides and Polymer B is selected from the group of polymethacrylates, poly alkyl acrylates, polymethacrylamides, and poly alkylacrylamides.

15. A polymerizable mixture as in item 8 wherein Polymer A is selected from the group of polyacrylates and polyacrylamides and Polymer B is selected from the group of polymethacrylates, poly alkyl acrylates, polymethacrylamides, and poly alkylacrylamides.

16. A polymerizable mixture as in item 15 wherein Polymer B comprises at least two different monomers.

17. A polymerizable mixture as in item 12 wherein Monomer A comprises at least two different monomers.

18. A polymerizable mixture as in item 12 wherein Monomer B comprises at least two different monomers.

19. A polymerizable mixture as in item 17 wherein Monomer B comprises at least two different monomers.

20. A polymerizable mixture as in item 15 wherein Polymer A is a copolymer of isooctyl acrylate and isobornyl acrylate and Polymer B is polybutyl methacrylate.

21. A polymerizable mixture as in item 15 wherein Polymer A is a copolymer of isooctyl acrylate and isobornyl acrylate and Polymer B is polyethyl methacrylate.

22. A polymerizable mixture as in item 16 wherein Polymer A is a copolymer of isooctyl acrylate and isobornyl acrylate and Polymer B is a copolymer of isobornyl methacrylate and butyl methacrylate.

23. A polymerizable mixture as in item 16 wherein Polymer A is a copolymer of isooctyl acrylate and isobornyl acrylate and Polymer B is a copolymer of ethyl methacrylate and butyl methacrylate.

24. A polymerizable mixture as in item 13 wherein Polymer A comprises polyphenoxyethyl acrylate and Polymer B comprises polybutyl methacrylate.

25. A vibration damping material prepared by the method comprising the steps:

a) providing at least two polymerizable mixtures, each comprising at least one ethylenically unsaturated monomer and a free-radical generating agent,
b) independently partially prepolymerizing each of said ethylenically unsaturated monomers to provide at least two partially prepolymerized syrups, and
c) combining said partially prepolymerized syrups and completing polymerization of said mixture.

26. A vibration damping material according to item 25 wherein said VDM has a tan delta ($\delta$) value greater than or equal to 0.4 at its intended use temperature and at 1 Hz.

27. A vibration damping material according to item 51 wherein said VDM has a tan delta ($\delta$) value greater than or equal to 0.4 over a frequency range from 0.1 to 10 Hz.

28. A vibration damping material according to item 27 wherein said VDM has an intended use temperature, said temperature being a single temperature value between -60 °C and 200 °C.

29. A vibration damping material according to item 25 wherein the utility window for a tan delta (δ) value greater than or equal to 0.4 at least one frequency between 0.1 at 10 Hz is at least 100 °C.

30. A vibration damping material according to item 25 wherein the utility window for a tan delta (δ) value greater than or equal to 0.6 at least one frequency between 0.1 at 10 Hz is at least 50 °C.

31. A vibration damping material according to item 30 wherein the storage modulus of said VDM is between $3.45 \times 10^5$ Pascals and $6.9 \times 10^6$ Pascals for at least one frequency between 0.1 and 10 Hz.

32. A vibration damping material according to item 30 wherein said VDM comprises Polymer A, Polymer B, and the polymerization product of Monomer A and Monomer B, wherein said Polymer A is selected from the group of polyacrylates and polyacrylamides and Polymer B is selected from the group of polymethacrylates, poly alkyl acrylates, polymethacrylamides, and poly alkylacrylamides, and Monomer A and Monomer B comprise acrylic monomers.

33. A vibration damping material according to item 32 wherein Polymer A is a copolymer of isooctyl acrylate and isobornyl acrylate and Polymer B is polybutyl methacrylate.

34. A vibration damping material according to item 32 wherein Polymer A is a copolymer of isooctyl acrylate and isobornyl acrylate and Polymer B is polyethyl methacrylate.

35. A vibration damping material according to item 32 wherein Polymer A is a copolymer of isooctyl acrylate and isobornyl acrylate and Polymer B is a copolymer of isobomyl methacrylate and butyl methacrylate.

36. A vibration damping material according to item 32 wherein Polymer A is a copolymer of isooctyl acrylate and isobornyl acrylate and Polymer B is a copolymer of ethyl methacrylate and butyl methacrylate.

37. A vibration damping device comprising a vibration damping material as described in item 25.

38. A vibration damping device comprising a vibration damping material as described in item 32.

39. A vibration damping device comprising a vibration damping material as described in item 25, said VDM being located and permanently attached between two rigid sheets.

40. A vibration damping device comprising a vibration damping material as described in item 32, said VDM being located and permanently attached between two rigid sheets.

41. A vibration damping device as in item 40 further comprising a second vibration damping material as in claim 8 and a third rigid sheet, said second VDM being located and permanently attached between said third rigid sheet and one of the other rigid sheet, forming an alternating stack of rigid sheets and VDM's.

## Examples

**Example 1**: A commercially available polyvinylbutyral (Butvar™, Monsanto Chemical Company, St. Louis, MO) co-polymer, 29 mol % vinyl alcohol, was converted to an acryloyloxy derivative by condensation of isocyanatoethylene methacrylate (IEMA) with the vinyl alcohol hydroxyl groups to the extent of 60 %. Coatings of this polymer with various organometallic compounds were cast from solutions comprising 2 g polymer (20 wt % in tetrahydrofuran, THF) and 0.1 g of the organometallic. The coatings were spread on polyester film with a #40 Meyer Bar and oven dried (1 min at 80°C). Samples were exposed to a medium pressure Hg source in a Berkey-Ascor vacuum frame through a square root of 2 step tablet (Stouffer Sensitivity Guide, Stouffer Graphic Arts Equipment Company, South Bend, IN), and immediately thereafter developed in isopropanol to reveal any negative resist image which may have been formed on the support by photocuring of the polymer. The data is shown in TABLE I, below in which the result, e.g., "solid 1" means that the coating was completely insolubilized by exposures greater than or equal to that reaching the sample through step #1 of a step tablet.

| TABLE I | | | |
|---|---|---|---|
| Acrylate Photoimaging | | | |
| Sample | Catalyst | Exposure time | Result |
| 1 | $MeCpMn(CO)_3$ | 2 min. | well defined resist; solid 1; "ghost" 2-3 |
| 2 | $[CpFe(CO)_2]_2$ | 2 min. | no image |
| 3 | $[CpW(CO)_3]_2$ | 2 min. | no image |
| 4 | $CpFe(CO)_3SnPh_3$ | 2 min. | no image |
| 5 | $(C_6H_6)Cr(CO)_3$ | 2 min. | well defined resist; solid 6, "ghost" 7 |
| 6 | none | 2 min. | no image |

The data show that neutral, mononuclear organometallic complexes containing polyene ligands and carbonyl ligands (samples nos. 1 and 5) are effective photocatalysts in free radical curing.

**Example 2** : A solution of acrylamide (1g., Aldrich Chemical Co.) and $MeCpMn(CO)_3$ (0.10 g., Aldrich Chemical Co.) in tetrahydrofuran (1 ml) was prepared and irradiated in a quartz cuvette for 2 min in front of a medium pressure Hg arc lamp. Absorption spectroscopy revealed a new band in the irradiated solution centered on 425 nm; no further changes were observed in this irradiated solution when it was allowed to stand in the dark. A solution of similar composition, similarly irradiated, was purged with dry nitrogen and sealed to exclude air; when this deoxygenated solution was allowed to stand, sealed, in the dark for an additional 96 h, the acrylamide was completely converted to insoluble polymer and the characteristic yellow color of the photoproduct had disappeared.

This Example illustrates that the photoreaction generates the initiator for the subsequent air-inhibited polymerization.

**Example 3**: Three syrups of approximately 2000 cps were prepared independently from IOA, IBA, and a 1:1 mixture of IOA and IBA. Samples for DMA were prepared from each of the three syrups and of a fourth syrup of approximately 2000 cps comprising a 1:1 mixture of the independently prepolymerized IOA and IBA syrups by adding 0.5°/° by weight KB-1 to the syrups, pouring each of the four syrups into 50 x 6 x 1 mm molds, covering the molds with a conventional silicone/polyester substrate release liner and a quartz plate (approximately 5 mm thick), and exposing the molds to 350 nm light for 10 minutes to complete the polymerization. The samples were tested on a Seiko Tensile DMS 200 DMA using a 2°C/min. heating rate. The cured IOA syrup showed a single Tg at -46°C, the cured IBA syrup showed a single Tg at 100°C, the cured syrup from the 1:1 mixture of IOA and IBA monomers showed a single Tg at 37°C, the cured sample from the 1:1 mixture of the IOA and IBA syrups showed two distinct Tgs at 4 and 91°C. The data is shown in TABLE II below.

| TABLE II | | | |
|---|---|---|---|
| Glass Transition Temperatures | | | |
| | Composition [a] | Initiator added after partial polymerization | Glass Transition Temperatures (Tg°C) |
| 1 | partially polymerized IOA (syrup A) | 0.5 wt percent KB-1 | -46 |
| 2 | partially polymerized IBA (syrup B) | 0.5 wt percent KB-1 | 100 |
| 3 | partially copolymerized IOA and IBA | 0.5 wt percent KB-1 | 37 |
| 4 | combination of syrups A and B | 0.5 wt percent KB-1 | 4 and 91 |
| [a] each partially polymerized syrup was initiated by 0.05 wt percent KB-1 | | | |

The data of Table II show that the use of mixtures of syrups causes increased phase separation which is not obtained from the monomers alone.

**Examples 4-9**: In the following examples the following abbreviations are used:

IOA, isooctyl acrylate
IBA, isobornyl acrylate
PhOEtA, phenoxy ethyl acrylate
BMA, n-butyl methacrylate
EMA, ethyl methacrylate
MMA, methyl methacrylate
IBMA, isobornyl methacrylate
HDDA, 1,6-hexane diol diacrylate
HDDMA, 1,6-hexane diol dimethacrylate,

In these examples, unless otherwise noted syrups were prepared as previously described for Examples 1-3. In the preparation of mixed syrups two or more separately prepared syrups were combined at the stated weight ratio to form a uniform mixture. In order to fabricate samples for DMA testing an ethylenically unsaturated crosslinker and a free radical initiator were added to the syrup or syrup mixture. Molds were made by cutting openings, approximately 3 to 15 square cm in area, in 0.076 mm thick silicone sheeting, and placing the silicone on conventional silicone/polyester substrate release liner. The syrups were poured into the molds, covered with conventional silicone/polyester substrate release liner to exclude oxygen , then exposed to 350 nm light to complete polymerization. DMA testing was done in either tension or shear mode at less than 1 % strain as indicated. Tension mode testing was done on a Seiko DMS 200 in heating mode at 2°C/min. Shear mode testing was done on a Seiko DMS 120 in cooling mode at 1 °C/min. Shear mode testing was continued until the force transducer could no longer deform the sample due to the high sample modulus at low temperature (generally G' > $5x10^7$ Pa). In examples where the sample properties were still in a desired range at this end of test condition, this temperature is reported as the minimum temperature of the utility window. Reported Glass Transition temperatures (Tg) are taken as the maximum or maxima in tan delta. Tension mode tests provide the tensile storage and loss moduli E' and E", while shear mode tests provide the shear storage and loss moduli G' and G". Tan delta values from tension and shear mode tests can be compared directly (i.e. tan delta - (G"/G') - (E"/E').

Table III summarizes all syrup compositions used to prepare samples for Examples 4-9. The syrups used were prepared as described!previously, using benzyl dimethyl ketal (KB-1) as the free radical photoinitiator at the weight percent listed, and were polymerized to the approximate weight percent conversion listed in the Table Table III. Table IV summarizes all mixed syrups used in Examples 4-9. The mixed syrups were prepared, as previously described, from combinations of the syrups listed in Table III

**TABLE III Syrup Compositions**

| Syrup | Composition | % KB-1 | % Conv. |
|---|---|---|---|
| A | IOA | 0.05 | 10 |
| B | IBA | 0.05 | 10 |
| C | PhOEtA | 0.01 | 7 |
| D | 2:1 IOA:IBA | 0.05 | 10 |
| E | 1:1 IOA:IBA | 0.05 | 8 |
| F | BMA | 0.05 | 33 |
| G | EMA | 0.05 | 31 |
| H | MMA | 0.05 | 30 |
| I | 2:3 IBMA:BMA | 0.05 | 30 |
| J | 1:1 BMA:MMA | 0.05 | 30 |
| K | 1:1 IOA:I BA | 0.05 | 10 |
| L | 4:1 PhOEtA:BMA | 0.04 | 10 |

**TABLE IV Mixed Syrup Compositions**

| Mixed Syrup | Composition I |
|---|---|
| M | 1:1 A:B |

(continued)

| Mixed Syrup | Composition I |
|---|---|
| N | 1:1 F:H |
| O | 4:1 C:F |
| P | 4:1 D:G |
| Q | 71:29 E:1 |

**Example 4**: To syrups D, G, and P were added 0.5 wt% KB-1 and 0.2 wt% HDDA. DMA samples were prepared as previously described by exposing the samples to 350 nm UV light for no less than 1 hour to complete polymerization. These examples were tested in shear mode DMA at frequencies of 0.1, 1, and 3 Hz, and the data is summarized in Table V. The G' utility window is defined as the temperature range over which the storage modulus (G') is within the range of 3.45 x $10^5$ Pa to 6.9 x $10^6$ Pa. When so indicated in Table, melt flow means that the sample exhibited melt flow at high temperature. Melt flow is generally undesirable for damping applications, thus materials which exhibit melt flow must be utilized below the melt flow temperature.

**TABLE V**

| Dynamic Mechanical Data For Example 4 | | | | | |
|---|---|---|---|---|---|
| Syrup or Mixed Syrup | Frequency (Hz) | Glass Transition Temperatures (°C) | tan $\delta$ > 0.6 utility window (°C) | tan $\delta$ > 0.4 utility window (°C) | G' utility window (°C) |
| D | 0.1 | -12 | -12 to 13 | -12 to 25 | -12 to -5 |
| G | 0.1 | 92 | 70 to melt flow | 70 to melt . flow | 80 to 98 |
| P | 0.1 | -3 and 85 | -5 to 15 and 79 to 91 | -5 to 102 | -4 to 31 |
| D | 1 | -4 | -12 to melt flow | -12 to melt flow | -8 to 5 |
| G | 1 | 95 | 70 to 108 | 66 to 119 | 85 to101 |
| P | 1 | 5 and 94 | -3 to 30 and 76 to 108 | -4 to 126 | 4 to 48 |
| D | 3 | 0 | -11 to melt flow | -12 to melt flow | -5 to 11 |
| G | 3 | 105 | 78 to melt flow | 72 to melt flow | 88 to 104 |
| P | 3 | 8 and 98 | 0 to 118 | -3 to 140 | 8 to 57 |

**Example 5:** Example 5 is a comparative example used to illustrate the current state of the art for seismic damping materials. A commercially available vibration damping material, 3M Scotchdamp™ ISD110, was tested in shear DMA as described previously. The DMA data are summarized in Table VI.

**TABLE VI**

| Dynamic Mechanical Data For Example 5 | | | | |
|---|---|---|---|---|
| Frequency (Hz) | Glass Transition Temperatures (°C) | tan $\delta$ > 0.6 utility window (°C) | tan $\delta$ > 0.4 utility window (°C) | G' utility window (°C) |
| 0.1 | 21 | 4 to 46 | 0 to 54 | 10 to 32 |
| 1 | 31 | 12 to 61 | 7 to 72 | 20 to 45 |
| 3 | 37 | 16 to 70 | 11 to 82 | 24 to 51 |

This example demonstrates that the mixed syrup composition provides a broader tan delta and G' utility window than that obtained from either of its components alone. The comparative example demonstrates that the mixed syrup composition has an even broader utility window than a commercially available damping material.

**Example 6**: To syrups Q and E were added 0.1 wt% KB-1 and 0.1 1 wt% HDDMA. DMA samples were prepared as previously described by exposing the samples to 350 nm UV light from both sides for no less than 150 min to complete polymerization. The samples were tested in shear mode DMA at a frequency of 1 Hz, and the data is summarized in Table VII.

**TABLE VII**

| | Dynamic Mechanical Data For Example 6 | | | |
|---|---|---|---|---|
| Syrup | Glass Transition Temperatures (°C) | tan δ> 0.6 utility window (°C) | tan δ> 0.4 utility window (°C) | G' utility window (°C) |
| Q | 32 and 86 | 26-43 and 74 to 110 | 23 to 145 | 30 to 71 |
| E | 17 | 9 to 49 | 9 to 68 | 12 to 25 |

The data of Table VII show that additional mixed syrup compositions beyond those described in Example 4 can be used to provide a wide utility window. The temperature range thus provided is approximately 2.5 times larger than that provided by a typical copolymer such as E.

**Example 7** : To syrups C, F, L and 0 were added 0.5 wt% KB-1 and 0.1 wt% HDDA. DMA samples were prepared as previously described by exposing the samples to 350 nm UV light from both sides for no less than 45 min to complete polymerization. The samples were tested in shear mode DMA at a frequency of 1 Hz, and the data is summarized in Table VIII.

**TABLE VIII**

| | Dynamic Mechanical Data For Example 7 | | |
|---|---|---|---|
| Syrup | Glass Transition Temperatures (°C) | tan δ > 0.6 utility window (°C) | tan 8 > 0.4 utility window (°C) |
| C | 22 | 18-45 | 18-54 |
| F | 58 | 44-54 | 40-90 |
| L | 16 | 14 to 48 | 14 to 125 |
| 0 | 20 and 42 | 10 to 74 | 13 to 113 |

The data of Table VIII show that the material prepared from the mixed syrup composition provides substantially a substantially wider tan delta utility window, than either the materials prepared from the individual syrups or the material prepared from a partially polymerized syrup of both monomers.

**Example 8** : To 8.8 grams syrup 0, was added 0.04 g KB-1 and 0.009 g HDDA, 3 g Lexorez 3500-90P linear poly (1,6 hexanediol neopentyl glycol phthalate adipate) (Inolex Industrial Chemicals, Philadelphia, PA), 0.20 g of Desmodur N-3300 triisocyanate, 0.56 g Desmodur W diisocyanate (both isocyanates from Miles Inc., Pittsburgh, PA), and 0.25 g CpFe(Xylenyl)$PF_6$ catalyst dissolved in approximately 0.06 g propylene carbonate. A second mixture was prepared, not containing the syrup, KB-1 or HDDA in order to make a urethane. DMA samples of the first mixture were prepared as previously described by exposing the molds to 420nm light from one side for 10 minutes to activate the CpFe(Xylenyl) $SbF_6$ catalyst, baking 15 min at 80 °C to begin the cure of the urethane, followed by exposure to 350nm light from both sides for 45 minutes to polymerize the (meth)acrylates, and baking 13 hours at 80°C to complete polymerization of the urethane. The DMA sample of the second mixture was prepared the same way, except that the exposure to 350nm light was omitted. The results of shear DMA testing done at 1 Hz in cooling mode at 1 °C/min are shown in Table IX.

**TABLE IX**

| | Dynamic Mechanical Data For Example 8 | | | |
|---|---|---|---|---|
| Syrup | Description of curable composition | Glass Transition Temperatures (°C) | tan δ > 0.6 utility window (°C) | tan δ > 0.4 utility window (°C) |
| 1 | Mixed Syrup O + Urethane | 2 and 67 | -7 to 102 | 7 to 145 |
| 2 | Urethane | 0 | -6 to 7 | -7 to 12 |

The data in Table IX, as compared to the data in the previous example demonstrate that the incorporation of an additional component can be used to further broaden the damping.

**Example 9- (methacrylate + methacrylate):** To syrups F, H, J and N were added 0.5 wt% KB-1 and 0.2 wt% HDDA. DMA samples were prepared as previously described by exposing the samples to 350 nm UV light for no less than 1 hour to complete polymerization. The samples were tested in tension mode DMA at a frequency of 1 Hz, and the data is summarized in Table X.

**TABLE X**

| Dynamic Mechanical Data For Example 9 | | | |
|---|---|---|---|
| Syrup | Glass Transition Temperatures (°C) | $\tan \delta > 0.6$ utility window (°C) | $\tan \delta > 0.4$ utility window (°C) |
| F | 52 | 36 to 62 | 32 to 72 |
| H | 124 | 112 to 135 | 110 to 139 |
| J | 78 | 65 to 92 | 63 to 98 |
| N | 80 and 108 | none | 68 to 119 |

Composition N has a broader tan delta utility window than either of its component compositions (F or H) or its corresponding composition random copolymer (N). This example shows that a broadened tan delta utility window can be obtained by using a mixed syrup composed entirely of methacrylates.

Various modifications and alterations of this invention will become apparent to those skilled in the art without departing from the scope and spirit of this invention, and it should be understood that this invention is not to be unduly limited to the illustrative embodiments set forth herein.

**Claims**

1. A curable composition comprising at least one ethylenically unsaturated monomer and as initiator a transition metal-containing organometallic compound having the formula

$$[L^1 L^2 M]$$

wherein

$L^1$ represents 1 ligand contributing pi-electrons that can be the same or different selected from acyclic and cyclic unsaturated compounds and groups and carbocyclic aromatic and heterocyclic aromatic compounds, each capable of contributing 2 to 24 pi-electrons to the valence shell of M;
$L^2$ represents 1 to 6 ligands that can be the same or different contributing an even number of sigma-electrons that can be selected from mono-, di-, and tri-dentate ligands, each donating 2, 4, or 6 sigma-electrons to the valence shell of M;
and M represents metal atom 1 to 4 of the same or different metal atoms selected from the elements of Periodic Groups IVB, VB, VIB, VIIB, and VIII (commonly referred to as transition metals).

2. A method comprising the steps:

a) providing at least two polymerizable mixtures, each comprising at least one ethylenically unsaturated monomers and a free-radical generating agent,
b) independently partially prepolymerizing each of said ethylenically unsaturated monomers to provide at least two partially prepolymerized syrups, and
c) combining said partially prepolymerized syrups and completing polymerization of said mixture.

3. A polymerizable mixture comprising two or more syrups, wherein each syrup comprises an acrylic polymer and an acrylic monomer, said acrylic polymers differing in either their monomer type or relative amount of each monomer type, said acrylic monomers differing in either their type or relative amount.

4. A vibration damping material prepared by the method as described in claim 2.

5. A vibration damping material according to claim 4 wherein the utility window for a tan delta (δ) value greater than or equal to 0.6 at least one frequency between 0.1 at 10 Hz is at least 50°C.

6. A vibration damping material according to claim 5 wherein said VDM comprises Polymer A, Polymer B, and the polymerization product of Monomer A and Monomer B, wherein said Polymer A is selected from the group of polyacrylates and polyacrylamides and Polymer B is selected from the group of polymethacrylates, poly alkyl acrylates, polymethacrylamides, and poly alkylacrylamides, and Monomer A and Monomer B comprise acrylic monomers.

7. A vibration damping device comprising a vibration damping material as described in claims 4 or 6, optionally said VDM being located and permanently attached between two rigid sheets.

**Patentansprüche**

1. Härtbare Zusammensetzung, umfassend mindestens ein ethylenisch ungesättigtes Monomer und als Initiator eine übergangsmetallhaltige metallorganische Verbindung mit der Formel

$$[L^1L^2M]$$

worin

$L^1$ für 1 Liganden steht, der Pi-Elektronen beiträgt, gleich oder verschieden sein kann und unter acyclischen und cyclischen ungesättigten Verbindungen und Gruppen und carbocyclischen aromatischen und heterocyclischen aromatischen Verbindungen ausgewählt ist, die jeweils 2 bis 24 Pi-Elektronen zur Valenzschale von M beitragen können;
$L^2$ für 1 bis 6 Liganden steht, die gleich oder verschieden sein können, eine gerade Zahl von Sigma-Elektronen beiträgt und unter ein-, zwei- und dreizähnigen Liganden ausgewählt sein kann, die jeweils 2, 4 oder 6 Sigma-Elektronen zur Valenzschale von M beitragen;
und M für 1 bis 4 gleiche oder verschiedene Metallatome steht, die unter den Elementen der Periodischen Gruppen IVB, VB, VIB, VIIB und VIII (die üblicherweise auch als Übergangsmetalle bezeichnet werden) ausgewählt sind.

2. Verfahren, umfassend die Schritte:

a) Bereitstellen von mindestens zwei polymerisierbaren Mischungen, die jeweils mindestens ein ethylenisch ungesättigtes Monomer und einen Radikalbildner umfassen,
b) unabhängiges teilweises Vorpolymerisieren jedes der ethylenisch ungesättigten Monomere zur Bereitstellung von mindestens zwei teilweise vorpolymerisierten Sirupen, und
c) Vereinigen der teilweise vorpolymerisierten Sirupe und Vervollständigen der Polymerisation der Mischung.

3. Polymerisierbare Mischung, umfassend zwei oder mehr Sirupe, wobei jeder Sirup ein Acrylpolymer und ein Acrylmonomer umfaßt, wobei die Acrylpolymere sich entweder in ihrer Monomerenart oder der relativen Menge jeder Monomerenart unterscheiden, und sich die Acrylmonomere entweder in ihrer Art oder ihrer relativen Menge unterscheiden.

4. Schwingungsdämpfendes Material, hergestellt nach dem Verfahren gemäß Anspruch 2.

5. Schwingungsdämpfendes Material nach Anspruch 4, wobei das Nutzungsfenster für einen tan-Delta (δ)-Wert größer gleich 0,6 bei mindestens einer Frequenz zwischen 0,1 bis 10 Hz mindestens 50°C beträgt.

**6.** Schwingungsdämpfendes Material nach Anspruch 5, wobei das SDM Polymer A, Polymer B und das Polymerisationsprodukt von Monomer A und Monomer B umfaßt, wobei Polymer A aus der Gruppe der Polyacrylate und Polyacrylamide ausgewählt ist, Polymer B aus der Gruppe der Polymethacrylate, Polyalkylacrylate, Polymethacrylamide und Polyalkylacrylamide ausgewählt ist und Monomer A und Monomer B Acrylmonomere umfassen.

**7.** Schwingungsdämpfungsvorrichtung, umfassend ein schwingungsdämpfendes Material gemäß Anspruch 4 oder 6, wobei das SDM gegebenenfalls zwischen zwei starren Flächengebilden angeordnet und dauerhaft angebracht ist.

**Revendications**

**1.** Composition durcissable comprenant au moins un monomère à insaturation éthylénique et comme amorceur un composé organométallique contenant un métal transitoire ayant la formule

$$[L^1L^2M]$$

dans laquelle

$L^1$ représente 1 ligand apportant des électrons pi qui peut être identique ou different, sélectionné parmi des composés et des groupes insaturés acycliques et cycliques et des composés aromatiques carbocycliques et aromatiques hétérocycliques, chacun capable d'apporter entre 2 et 24 électrons pi à l'enveloppe de valence de M ;
$L^2$ représente entre 1 et 6 ligands qui peuvent être identiques ou différents, apportant un nombre pair d'électrons sigma, qui peuvent être sélectionnés parmi les ligands monodentés, bidentés et tridentés, chacun apportant 2, 4 ou 6 électrons sigma à l'enveloppe de valence de M ;
et M représente entre 1 et 4 atomes du même métal ou de différents métaux sélectionnés parmi les éléments des Groupes Périodiques IVB, VB, VIB, VIIB, et VIII (désignés couramment par le terme « métaux transitoires »).

**2.** Méthode comprenant les étapes qui consistent à :

a) fournir au moins deux mélanges polymérisables, chacun comprenant au moins un monomère à insaturation éthylénique et un agent produisant des radicaux libres,
b) prépolymériser indépendamment et en partie chacun desdits monomères à insaturation éthylénique pour produire au moins deux sirops partiellement prépolymérisés, et
c) combiner lesdits sirops partiellement prépolymérisés et achever la polymérisation dudit mélange.

**3.** Mélange polymérisable comprenant deux sirops ou plus, dans lequel chaque sirop comprend un polymère acrylique et un monomère acrylique, lesdits polymères acryliques différant soit par leur type de monomère, soit par la quantité relative de chaque type de monomère, lesdits monomères acryliques différant soit par leur type, soit par leur quantité relative.

**4.** Matériau d'amortissement des vibrations préparé par la méthode selon la revendication 2.

**5.** Matériau d'amortissement des vibrations selon la revendication 4, dans lequel la fenêtre d'utilisation pour une valeur tan delta (δ) supérieure ou égale à 0,6 à au moins une fréquence entre 0,1 et 10 Hz est d'au moins 50 ºC.

**6.** Matériau d'amortissement des vibrations selon la revendication 5, dans lequel ledit matériau d'amortissement des vibrations comprend le Polymère A, le Polymère B, et le produit de polymérisation du Monomère A et du Monomère B, dans lequel ledit Polymère A est sélectionné dans le groupe constitué des polyacrylates et des polyacrylamides et le Polymère B est sélectionné dans le groupe constitué des polyméthacrylates, des polyalkylacrylates, des polyméthacrylamides, et des polyalkylacrylamides, et le Monomère A et le Monomère B comprennent des monomères acryliques.

**7.** Dispositif d'amortissement des vibrations comprenant un matériau d'amortissement des vibrations selon la revendication 4 ou 6, ledit matériau d'amortissement des vibrations étant éventuellement positionné et fixé à titre permanent entre deux feuilles rigides.